# EUROPEAN PATENT SPECIFICATION

(11) **EP 1 020 892 B1**
(45) Date of publication and mention of the grant of the patent: **18.08.2004**
(21) Application number: 99870006.6
(22) Date of filing: 14.01.1999
(51) Int. Cl.: H01J 37/32

(54) **Apparatus for the deposition of coatings on a substrate using a magnetically confined inductively coupled plasma source**
Vorrichtung zum Aufbringen von Beschichtungen auf ein Substrat durch eine induktiv-angekoppelte magnetisch-begrenzte Plasmaquelle
Dispositif pour le dépôt de couches sur un substrat utilisant une source de plasma à couplage inductif et confinement magnétique

(43) Date of publication of application: 19.07.2000
(73) Proprietor: VLAAMSE INSTELLING VOOR TECHNOLOGISCH ONDERZOEK (VITO), 2400 Mol (BE)
(72) Inventor: Dekempeneer, Erik, B-2390 Oostmalle (BE)
(74) Representative: Van Malderen, Joelle

(56) References cited:
- WO-A-96/15545
- FR-A- 2 693 620
- US-A- 5 436 528
- US-A- 5 637 358

## Description

### Field of the invention

This invention is situated in the field of apparatus for deposition of coatings on a substrate using magnetically confined planar inductively coupled plasma deposition methods.

### State of the art

Coatings can be deposited on virtually any substrate using plasma deposition methods. One possible deposition method makes use of a magnetically confined planar inductively coupled plasma (ICP) source. The plasma is excited by induction from an r.f. coil and is formed below an insulating window in the reactor volume. This insulating window also closes off the vacuum.

Magnets are often used to enhance the plasma density. The substrate to be coated is traditionally placed on a substrate holder some distance below the window. This distance is typically a few centimetres. The substrate holder can be biased to enhance the ionic bombardment on the substrate during film growth to tailor the coating properties. Such apparatus is described in, for example, US 5 436 528.

An important disadvantage of this setup is the fact that the insulating window is not protected from the plasma and therefore becomes coated with a film. This contamination of the window can sometimes modify the plasma conditions as a function of time. It also can spall off spontaneously after a while making it necessary to clean the window on a regularly basis. It also can lead to unwanted contamination (via sputtering) of the coating on the substrate holder and any substrate placed on it. A possible way to reduce the sputter contamination on the substrate side is to install an earthed Faraday shield below the r.f. coil, and separated from it through an insulating cover, to reduce the capacitive coupling. However, this Faraday shield does not avoid the contamination of the insulating window itself.

The ICP technology can be scaled up to large dimensions by placing more than one induction coil next to each other.

### Aims of the invention

A primary aim of the present invention is to provide an apparatus for coating a substrate using ICP plasma deposition, wherein the insulating window does not get contaminated.

A further aim of the present invention is to provide an apparatus for coating a substrate using ICP plasma deposition, wherein the plasma conditions do not change with time.

### General description of the invention

The present invention concerns an apparatus for the deposition of coating layers on a substrate using a magnetically confined planar inductively coupled plasma source, characterised in that said apparatus comprises a plasma inductor, a vacuum reactor comprising an insulating window, said reactor containing gases containing the elements that are to be deposited, characterised in that the substrate to be coated is placed close to said insulating window such as to cover at least part of said insulating window where it becomes coated from the plasma side. Preferably, substrate covers the insulating window completely.

The apparatus according to the present invention can further comprise a Faraday shield, said Faraday shield preferably being biased.

The apparatus according to the present invention is preferably characterised in that the plasma inductor comprises an induction coil driven by a power supply, said power supply being advantageously selected from the group consisting of r.f. , a.c., and pulsed d.c. power supplies.

The apparatus according o the present invention can further comprise means to move the substrate, to ensure e.g. that a large substrate, such as a foil, is evenly coated on its complete surface facing away from the window.

### Short description of the figures:

Figure 1 describes a traditional setup of a plasma deposition reactor based on a magnetically confined planar ICP source and a counterfacing substrate to be coated on its substrateholder (state of the art).
Figure 2 shows the setup of a plasma deposition reactor, according to the present invention, using a magnetically confined planar ICP source and a facility to guide the substrate to be coated close to the insulating source window where it becomes coated from the plasma side. In this schematic drawing the substrate is schematically represented by a foil which is guided by a combination of two rollers (roll-on and roll-off).

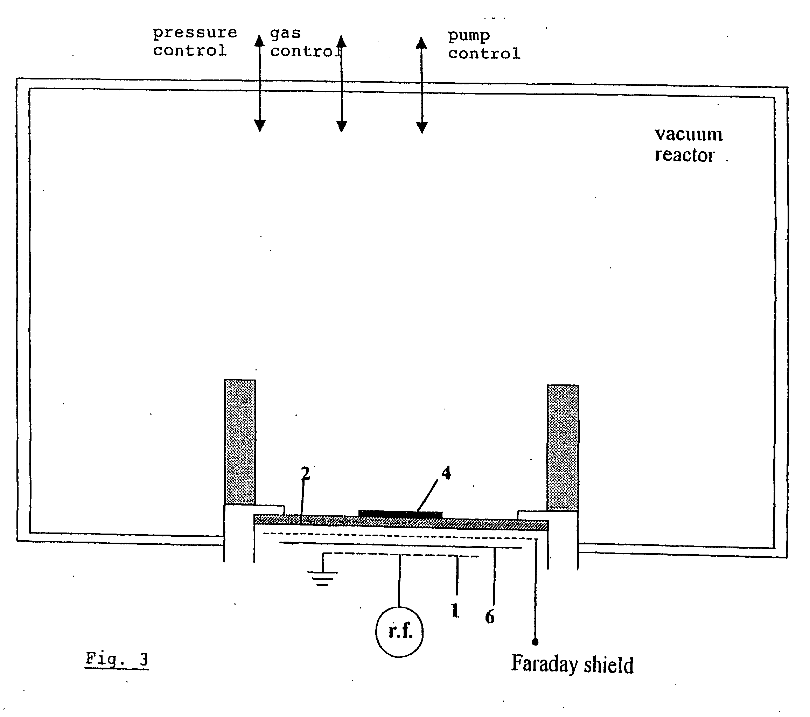

Figure 3 depicts the setup of a plasma deposition reactor, according to another embodiment of the present invention, using a magnetically confined planar ICP source and a substrate to be coated placed on the source window where it becomes coated from the plasma side.

### Detailed description of the invention

The present invention relates to an apparatus for coating a substrate using ICP plasma deposition, wherein the insulating window is protected from the plasma by the substrate itself. The invention will be further clarified using several non-limiting examples and figures.

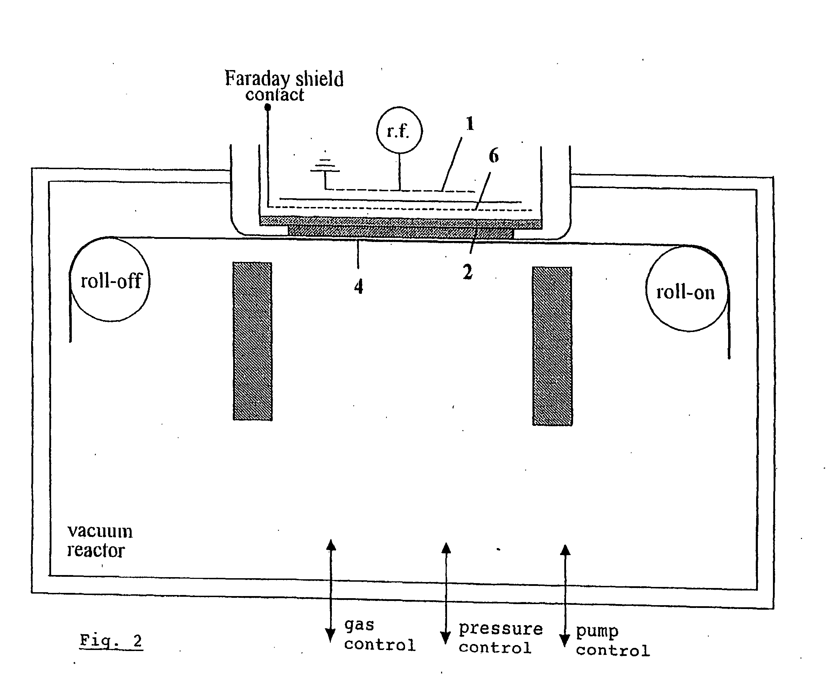

According to the present invention, the substrate to be coated (4) is guided adjacent to the insulating window 2 (covering it) as for example indicated in figure 2 which schematically represents a web coating application where rolls of foil have to be coated (the foil is moving at a certain linespeed). The roll-on and roll-off stage are used to guide the foil substrate.

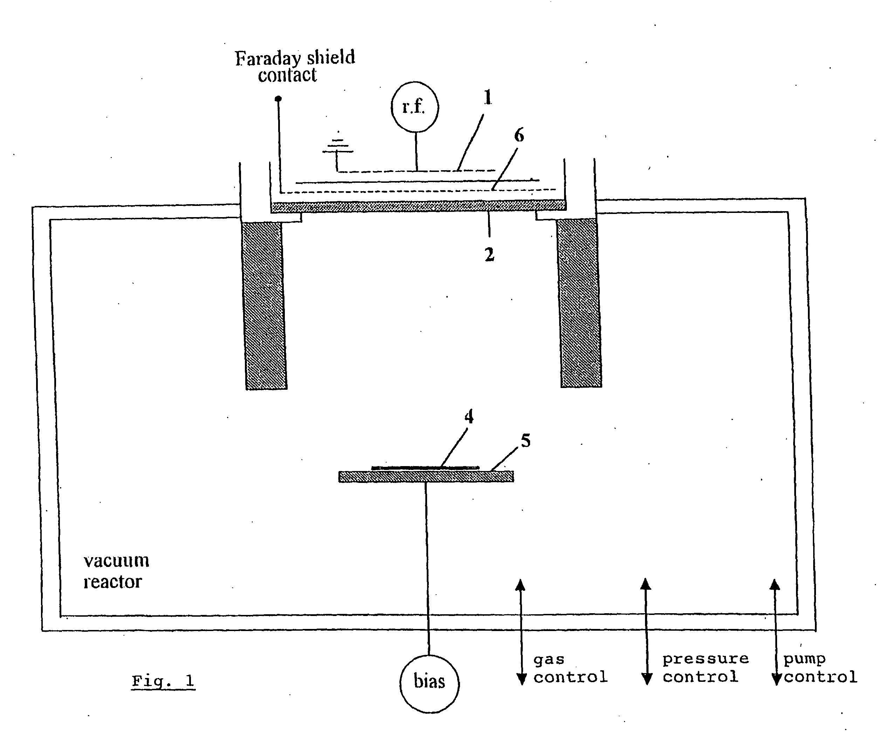

The layer which in the traditional setup (figure 1) was considered as a disturbing contamination layer on the insulating window is now deposited directly on the substrate to be coated.

The properties of this coating can be tailored in a very broad range more or less in a similar way as the coating on the substrate in the traditional setup (figure 1) could be tailored. In the configuration according to the invention the window remains clean and needs no further maintenance. An additional advantage of the new setup is that the plasma density is maximum close to the insulating window so that in the configuration according to the invention one benefits most from the high plasma density of the ICP source.

Available procesparameters to tailor coating properties in the setup according to the invention are:
- gas flow properties,
- working pressure,
- r.f. power to the coil (1),
- the presence or absence of an earthed Faraday shield (6) .

The latter is a very important process parameter. In the absence of the Faraday shield the capacitive coupling component from the induction coil induces a self-biasing of the substrate (4) in figure 2 inducing an enhanced ionic bombardment during film growth. In the presence of the earthed Faraday shield, this biasing is effectively zero.

The biasing of the substrate (4) in figure 2 can be controlled even more precisely when applying a separate bias power supply to the Faraday shield (6) (replace the earth connection with a separate bias power supply). For example, by connecting a pulsed d.c. power supply to the Faraday shield in the frequency range 10 - 400 kHz with controllable peak voltage, the bias voltage on the substrate (4) in figure 2 can be controlled precisely.

In order to improve the plasma uniformity on the substrate (4) in the configuration of figure 2 it is possible to develop special magnet configurations controlling the plasma density distribution. This may become necessary when more than one r.f. coil are placed next to each other to increase the source dimension and where the plasma density between the coils needs to be adjusted.

### Example 1

A substrate (4) was placed against the insulating window (2) (diameter 20 cm). The gas flow consisted of 2,4 standard l/h (40 sccm) CH₄ and 0,6 standard l/h (10 sccm) H₂. The pressure was fixed at 1.5 Pa. The r.f. power was set at 100 W. The Faraday shield was absent. The coating deposited on the substrate was dark brown and showed an excellent wear resistance against rubbing with rough sandpaper. This coating showed all properties typical of a conventional hard α-C:H diamond-like carbon coating.

### Example 2

A substrate (4) was placed against the insulating window (2) (diameter 20 cm). The gas flow consisted of 2,4 standard l/h (40 sccm) CH₄ and 0,6 standard l/h (10 sccm) H₂. The pressure was fixed at 1.5 Pa. The r.f. power was set at 100 W. An earthed Faraday shield was present. The coating deposited on the substrate was completely transparent. This coating has all properties typical of a conventional transparent plasma polymer.

### Example 3

α-SiₓC₁₋ₓ:H, α-CₓF₁₋ₓ:H, α-BₓN₁₋ₓ:H, and α-SiₓO_{y}N_{z}:H layers can be coated on substrates in a configuration according to the present invention.

Gas flows, working pressures, r.f. powers can all be varied in a wide range. By choosing the appropriate gases virtually any coating composition can be deposited on a substrate using the method according to this invention. It is even possible to replace the r.f. power supply to the induction coils by other a.c. or pulsed d.c. power supplies. The configuration according to the invention can possibly be used to plasma activate or clean substrates without deposition.

## Claims

1. Apparatus for the deposition of coating layers on a substrate (4) using a magnetically confined planar inductively coupled plasma source, **characterised in** said apparatus comprising a plasma inductor, a vacuum reactor comprising an insulating window (2), said reactor containing gases containing the elements that are to be deposited, **characterised in that** the substrate to be coated is placed close to said insulating window such as to cover at least part of said insulating window and the substrate becomes coated from the plasma side.

2. Apparatus such as in claim 1, **characterised in that** the substrate (4) covers the insulating window (2) completely.

3. Apparatus such as in claim 1 or 2, **characterised in that** the apparatus further comprises a Faraday shield (6).

4. Apparatus such as in claim 3, **characterised in that** the Faraday shield is biased.

5. Apparatus such as in any of the claims 1 to 4, **characterised in that** the plasma inductor comprises an induction coil (1) driven by a power supply, said power supply being selected from the group consisting of r.f. , a.c., and pulsed d.c. power supplies.

6. Apparatus such as in any of the claims 1 to 5, **characterised in that** the apparatus further comprises means to move the substrate.

## Patentansprüche

1. Vorrichtung für die Abscheidung von Beschichtungsschichten auf einem Substrat (4) unter Einsatz einer magnetisch eingeschlossenen, planaren, induktiv gekoppelten Plasmaquelle, wobei die besagte Vorrichtung einen Plasmainduktor, einen ein Isolierfenster (2) umfassenden Vakuumreaktor umfasst, wobei der besagte Reaktor die Gase enthält, die die abzuscheidenden Elemente enthalten, **dadurch gekennzeichnet, dass** das zu beschichtende Substrat so nah am besagten Isolierfenster angeordnet ist, dass es zumindest einen Teil des besagten Isolierfensters bedeckt und das Substrat von der Plasmaseite beschichtet wird.

2. Vorrichtung nach Anspruch 1, **dadurch gekennzeichnet, dass** das Substrat (4) das Isolierfenster (2) vollständig bedeckt.

3. Vorrichtung nach Anspruch 1 oder 2, **dadurch gekennzeichnet, dass** die Vorrichtung ferner eine Faraday-Abschirmung (6) umfasst.

4. Vorrichtung nach Anspruch 3, **dadurch gekennzeichnet, dass** die Faraday-Abschirmung vorgespannt ist.

5. Vorrichtung nach irgendeinem der Ansprüche 1 bis 4, **dadurch gekennzeichnet, dass** der Plasmainduktor eine Induktionsspule (1), die durch eine Energiequelle betrieben wird, umfasst, wobei die besagte Energiequelle ausgewählt ist aus der Gruppe, bestehend aus Hochfrequenz-, Wechselstrom- und Impuls-Gleichstromenergiequellen.

6. Vorrichtung nach irgendeinem der Ansprüche 1 bis 5, **dadurch gekennzeichnet, dass** die Vorrichtung ferner Mittel zum Bewegen des Substrats umfasst.

## Revendications

1. Dispositif pour le dépôt de couches de revêtement sur un substrat (4) utilisant une source de plasma planaire à couplage inductif et confinement magnétique, ledit dispositif comprenant un inducteur de plasma, un réacteur sous vide comprenant une fenêtre isolante (2), ledit réacteur contenant des gaz contenant les éléments à déposer, **caractérisé en ce que** le substrat à revêtir est placé à proximité de ladite fenêtre isolante de façon à recouvrir au moins une partie de ladite fenêtre isolante et à faire en sorte que le substrat soit revêtu du côté plasma.

2. Dispositif selon la revendication 1, **caractérisé en ce que** le substrat (4) recouvre complètement la fenêtre isolante (2).

3. Dispositif selon la revendication 1 ou 2, **caractérisé en ce que** le dispositif comprend en outre un écran Faraday (6).

4. Dispositif selon la revendication 3, **caractérisé en ce que** l'écran Faraday est polarisé.

5. Dispositif selon l'une quelconque des revendications 1 à 4, **caractérisé en ce que** l'inducteur de plasma comprend une bobine d'induction (1) excitée par une source d'énergie, ladite source d'énergie étant choisie dans le groupe constitué des sources d'énergie r.f., c.a. et c.c. pulsé.

6. Dispositif selon l'une quelconque des revendications 1 à 5, **caractérisé en ce que** le dispositif comprend en outre des moyens pour déplacer le substrat.
